# EUROPÄISCHE PATENTSCHRIFT

(11) **EP 2 690 763 B1**
(45) Veröffentlichungstag und Bekanntmachung des Hinweises auf die Patenterteilung: **26.04.2017**
(21) Anmeldenummer: 12178029.0
(22) Anmeldetag: 26.07.2012
(51) Int. Cl.: H02K 29/08, H05K 3/30, H02K 5/128

(54) **Elektromotorische Kfz-Flüssigkeits-Förderpumpe**
Electric fluid pump for a motor vehicle
Pompe de transport de liquide à moteur électrique pour véhicule automobile

(43) Veröffentlichungstag der Anmeldung: 29.01.2014
(73) Patentinhaber: Pierburg Pump Technology GmbH, 41460 Neuss (DE)
(72) Erfinder: Lindner, Enrico, 09322 Penig (DE); Zacher, Wolfgang, Dr., 04720 Döbeln (DE)
(74) Vertreter: Patentanwälte ter Smitten Eberlein-Van Hoof Rütten Partnerschaftsgesellschaft mbB

(56) Entgegenhaltungen:
- EP-A1- 0 786 856
- EP-A1- 2 187 718
- DE-A1- 2 348 683
- DE-A1- 4 136 816
- DE-A1- 4 411 960
- DE-A1- 10 045 596

## Beschreibung

Die Erfindung betrifft eine elektromotorische Kfz-Flüssigkeits-Förderpumpe mit einem Gehäuse, in dem ein elektrisch kommutierter Motorstator und ein permanent erregter Motorrotor, der auf einer Rotorwelle/-achse angeordnet ist, vorgesehen sind, wobei in einem Trockenbereich des Gehäuses eine Vergussmasse freie Leiterplatte vorgesehen ist, die zumindest einen auf einem Abstandsorgan angeordneten berührungslosen Sensor zur Erfassung einer Rotorposition sowie weitere elektronische Bauteile aufweist, welche über Anschlussdrähte elektrisch mit der Leiterplatte verbunden sind.

Derartige Förderpumpen sind hinlänglich bekannt und werden beispielsweise als Kühlmittelpumpen eingesetzt. Um eine Rotorlage-Information für die elektrische Kommutierung zu erhalten, ist ein berührungslose Sensor, beispielsweise ein Hallsensor, vorgesehen. Des Weiteren sind weitere elektronische Bauteile, beispielsweise zur Ansteuerung der Kommutierung, auf einer Leiterplatte angeordnet. Eine derartige Flüssigkeits-Förderpumpe ist beispielsweise aus der EP 1 850 010 A2 bekannt. Es hat sich nun herausgestellt, dass die Lebensdauer der Leiterplatte und damit auch der Pumpe durch ein sogenanntes Dendritenwachstum auf der Leiterplatte als Folge von nach der Bestückung vorhandenen Rückständen in erheblichem Maße verringert wird. Auch die Reinigung der Leiterplatte in einem sogenannten Freiwaschprozess stößt insbesondere in den Bereichen der Elektronikbauteile und des Hallsensors dahingehend auf Probleme, dass in diesen Bereichen die Rückstände nicht vollständig beseitigt werden können. In diesem Zusammenhang ist aus der DE 41 36 816 A1 ein Reinigungsverfahren bzw. eine Reinigungsanlage zur Reinigung von Schaltplatinen bekannt. Auch ist es in dem vorliegenden Anwendungsfall einer Kfz-Flüssigkeits-Förderpumpe nicht möglich, die Leiterplatte beispielsweise mit einer Vergussmasse zu überziehen, um diese Nachteile zu verhindern oder zu zumindest zu verringern, da aufgrund der hohen Temperaturentwicklung in einer derartigen Förderpumpe die Leiterplatte frei von derartigen Beschichtungen bleiben muss. Aus der DE 100 45 596 A1 ist eine Förderpumpe bekannt, bei der zwecks optimaler Ausrichtung Sensoren auf Halterelementen angeordnet sind. Auch aus der EP 0 786 856 A1 sind Halteteile bekannt, auf denen jeweils ein berührungsloser Hall-Sensor über Abstandsorgane beabstandet angeordnet ist. Des Weiteren ist noch die DE 23 48 683 A1 als Stand der Technik zu nennen, die ebenfalls Halteteile für eine Leiterplatte offenbart, wobei durch das Vorsehen von Kühlkanälen großflächige Zonen entstehen. Die oben genannten Nachteile liegen jedoch auch bei diesen Ausführungsformen vor. Die DE44 11 960 A1 offenbart eine elektromotorische Kfz-Flüssigkeitsförderpumpe gemäß Oberbegriff des Anspruchs 1.

Der Erfindung liegt daher die Aufgabe zugrunde, eine elektromotorische Kfz-Flüssigkeits-Förderpumpe bereitzustellen, die auf kostengünstige und montagetechnisch einfache Weise die oben genannten Nachteile vermeidet.

Diese Aufgabe wird dadurch gelöst, dass ein Halterelement vorgesehen ist, auf dem der berührungslose Sensor und die Elektronikbauteile angeordnet sind und das über die Abstandsorgane von der Leiterplatte beabstandet angeordnet ist, wobei das Halterelement mittels einer Clipsverbindung mit der Leiterplatte verbunden ist, so dass großflächige Freiwaschzonen geschaffen werden, die eine rückstandsfreie Reinigung der Leiterplatte nach der Bestückung gewährleisten.. Hierdurch ist es möglich, dass der Freiwaschvorgang nach der Bestückung der Leiterplatte möglichst effizient und vollständig durchgeführt werden kann. Es können sich keine Rückstände an den extrem strömungsgünstig ausgebildeten Abstandsorganen bilden, wodurch das Dendritenwachstum weitestgehend unterbunden werden kann. Darüber hinaus ist eine einfache Vormontage des berührungslosen Sensors und der elektronischen Bauteile gewährleistet. In vorteilhafter Weise können die Abstandsorgane integraler Bestandteil von Zentrierorganen für den berührungslosen Sensor, die Elektronikbauteile und/oder das Halterelement sein. In vorteilhafter Weise ist der Motorrotor außenliegend und der Motorstator innenliegend ausgeführt. Hierbei kann ein Spalttopf den Nassbereich mit dem Motorrotor und einem Pumpenrotor von dem den Motorstator aufweisenden Trockenbereich trennen.

In vorteilhafter Weise ist auf der Platine eine Steuereinheit vorgesehen. Für eine einfache Montage kann es zudem vorteilhaft sein, wenn die Platine nur auf ihrer Motor zugewandten Seite einseitig bestückt ist.

Vorzugsweise ist die Förderpumpe eine Kühlmittelpumpe, da sich die erfindungsgemäße Förderpumpe insbesondere durch ihre kompakte und kostengünstige Bauweise für den Einsatz im Bauraum begrenzten Motorinnenraum zur Kühlmittelförderung eignet.

Die Erfindung wird anhand einer Zeichnung näher beschrieben, hierbei zeigt:
Figur 1 eine perspektivische, aufgeschnittene Ansicht einer erfindungsgemäßen elektromotorischen Kfz-Flüssigkeits-Förderpumpe, und
Figur 2 eine Seitenansicht einer Leiterplatte mit einem Halterelement für die Kfz-Flüssigkeits-Förderpumpe aus Figur 1.

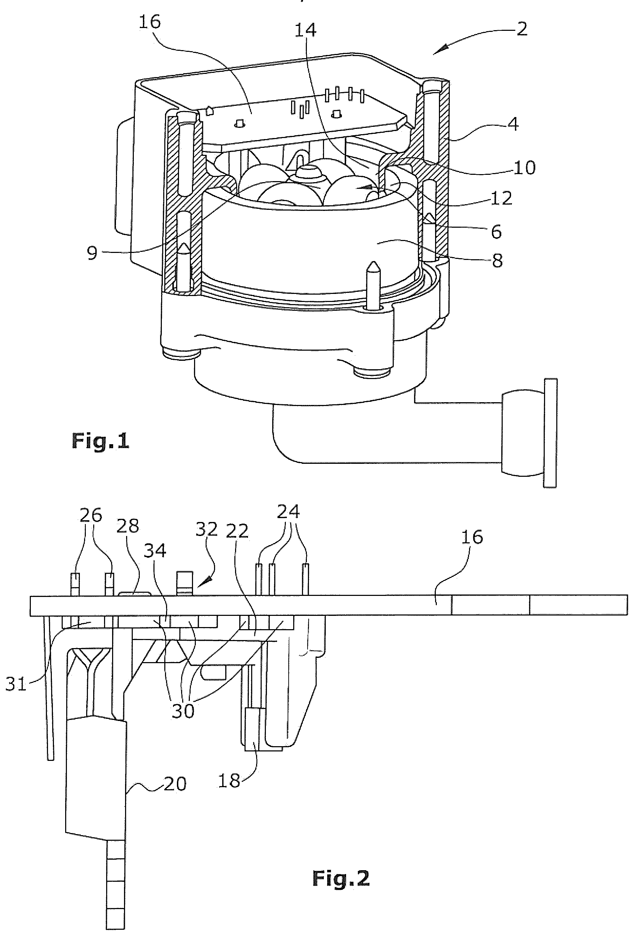

Figur 1 zeigt eine erfindungsgemäße Kfz-Flüssigkeits-Förderpumpe 2 mit einem Gehäuse 4, in dem ein elektronisch kommutierter Motorstator 6 sowie ein permanent erregter Motorrotor 8 vorgesehen sind. Der Motorrotor 8 ist im vorliegenden Ausführungsbeispiel außenliegend auf einer Rotorachse 9 und der Motorstator 6 innenliegend angeordnet. Des Weiteren ist ein Spalttopf 10 vorgesehen, derart, dass der Motorrotor 8 in einem Nassbereich 12 und der Motorstator 6 in einem Trockenbereich 14 angeordnet ist. Es sollte deutlich sein, dass der Motorrotor 8 anstatt auf einer Rotorachse 9 auch auf einer Rotorwelle angeordnet sein kann.

Des Weiteren ist in dem Gehäuse 4 eine Vergussmasse freie Leiterplatte 16 angeordnet, die lediglich auf ihrer dem Motor 6, 8 zugewandten Seite einseitig mit einem berührungslosen Sensor 18 und weiteren Elektronikbauteilen, wie zum Beispiel einer Steuereinheit 20 (siehe hierzu Figur 2) bestückt ist. Diese Anordnung stellt jedoch nur eine Ausführungsform dar. Es ist natürlich auch eine doppelseitige Bestückung der Leiterplatte 16 möglich. Die Kfz-Flüssigkeits-Förderpumpe 2 weist einen durch das Gehäuse 4 verdeckten Pumpenrotor auf, der auf dem von den Leiterplatte 16 abgewandten Ende der Kfz-Flüssigkeits-Förderpumpe 2 angeordnet ist.

Figur 2 zeigt in einer Seitenansicht die Leiterplatte 16 mit einem Halterelement 22. Auf dem Halterelement 22 sind der Hallsensor 18 und die Steuereinheit 20 befestigt und auf bekannte Weise über Anschlussdrähte 24, 26 elektrisch mit der Leiterplatte 16 verbunden.

Im vorliegenden Ausführungsbeispiel weist das Halterelement 22 Zentrierelemente 28 (von denen ist hier lediglich eins dargestellt) sowie Abstandsorgane 30 auf, die integraler Bestandteil des Halterelementes 22 sind. Es sollte deutlich sein, dass sowohl Zentrierorgane 28 als auch Abstandsorgane 30 auch integraler Bestandteil der Leiterplatte sein können und dann mit dem Halterelement 22 korrespondieren. Über eine Clipsverbindung 32 ist das Halterelement mit der Leiterplatte 16 verbunden. Hierdurch werden großflächige Freiwaschzonen 34 geschaffen, wodurch eine rückstandsfreie Reinigung der Leiterplatte 16 nach der Bestückung gewährleistet ist. Ein Dendritenwachstum und die damit verbundene Verringerung der Lebensdauer der Kfz-Flüssigkeits-Förderpumpe 2 wird hierdurch wirksam unterbunden.

## Patentansprüche

1. Elektromotorische Kf2-Flüssigkeits-Förderpumpe (2) mit einem Gehäuse (4), in dem ein elektrisch kommutierter Motorstator (6) und ein permanent erregter Motorrotor (8), der auf einer Rotorwelle/-achse (9) angeordnet ist, vorgesehen sind, wobei in einem Trockenbereich (14) des Gehäuses (4) eine Vergussmasse freie Leiterplatte (16) vorgesehen ist, die zumindest einen auf einem Abstandsorgan (30) angeordneten berührungslosen Sensor (18) zur Erfassung einer Rotorposition sowie weitere elektronische Bauteile (20) aufweist, welche über Anschlussdrähte (24, 26) elektrisch mit der Leiterplatte (16) verbunden sind, **dadurch gekennzeichnet, dass** ein Halterelement (22) vorgesehen ist, auf dem der berührungslose Sensor (18) und die Elektronikbauteile (20) angeordnet sind und das über die Abstandsorgane (30) von der Leiterplatte (16) beabstandet angeordnet ist, wobei das Halterelement (22) mittels einer Clipsverbindung (32) mit der Leiterplatte (16) verbunden ist, so dass großflächige Freiwaschzonen (34) geschaffen werden, die eine rückstandsfreie Reinigung der Leiterplatte (16) nach der Bestückung gewährleisten.

2. Elektromotorische Kfz-Flüssigkeits-Förderpumpe (2) nach Anspruch 1, **dadurch gekennzeichnet, dass** die Abstandsorgane (30) integraler Bestandteil von Zentrierorganen (28) sind.

3. Elektromotorische Kfz-Flüssigkeits-Förderpumpe (2) nach Anspruch 1 oder 2, **dadurch gekennzeichnet, dass** der Motorrotor (8) außenliegend und der Motorstator (6) innenliegend ausgeführt ist.

4. Elektromotorische Kfz-Flüssigkeits-Förderpumpe (2) nach einem der vorhergehenden Ansprüche, **dadurch gekennzeichnet, dass** ein Spalttopf (10) den Nassbereich (12) mit dem Motorrotor (8) und einem Pumpenrotor von dem den Motorstator (6) aufweisenden Trockenbereich (14) trennt.

5. Elektromotorische Kfz-Flüssigkeits-Förderpumpe (2) nach einem der vorhergehenden Ansprüche, **dadurch gekennzeichnet dass** auf der Leiterplatte (16) eine Steuereinheit (20) vorgesehen ist.

6. Elektromotorische Kfz-Flüssigkeits-Förderpumpe (2) nach einem der vorhergehenden Ansprüche, **dadurch gekennzeichnet, dass** die Leiterplatte nur auf ihrer dem Motor (6, 8) zugewandten Seite einseitig bestückt ist.

7. Elektromotorische Kfz-Flüssiglceits-Förderpumpe (2) nach einem der vorhergehenden Ansprüche, **dadurch gekennzeichnet, dass** die Förderpumpe (2) eine Kühlmittelpumpe ist.

## Claims

1. Electric fluid pump (2) for a motor vehicle, comprising a housing (4) in which an electrically commutated motor stator (6) and a permanently excited motor rotor (8) are provided, said motor rotor being arranged on a rotor shaft/axle (9), wherein in a dry region (14) of the housing (4) a circuit board (16) free of potting compound is provided which comprises at least one contactless sensor (18) arranged on a spacer element (30) for detecting a rotor position, as well as further electronic components (20) electrically connected with the circuit board via connecting wires (24, 26), **characterized in that** a retaining element (22) is provided on which the contactless sensor (18) and the electronic components (20) are arranged and which is arranged at a distance from the circuit board (16) by means of the spacer elements (30), wherein the retaining element (22) is connected with the circuit board (16) by means of a clip connection (32) so that large cleansing zones (34) that allow the circuit board (16) to be cleaned without residue after having been assembled.

2. Electric fluid pump (2) for a motor vehicle of claim 1, **characterized in that** the spacer elements (30) are an integral part of centering elements (28).

3. Electric fluid pump (2) for a motor vehicle of claim 1 or 2, **characterized in that** the motor rotor (8) is designed as an external rotor and the motor stator (6) is designed as an internal stator.

4. Electric fluid pump (2) for a motor vehicle of one of the preceding claims, **characterized in that** a can (10) separates the wet region (12) with the motor rotor (8) and a pump rotor from the dry region (14) including the motor stator (6).

5. Electric fluid pump (2) for a motor vehicle of one of the preceding claims, **characterized in that** a control unit (20) is provided on the circuit board (16).

6. Electric fluid pump (2) for a motor vehicle of one of the preceding claims, **characterized in that** the circuit board is assembled only on one side which is the side directed towards the motor (6, 8).

7. Electric fluid pump (2) for a motor vehicle of one of the preceding claims, **characterized in that** the pump is a coolant pump.

## Revendications

1. Pompe de transport de liquide (2) à moteur électrique pour véhicule automobile avec un carter (4) dans lequel sont agencés un stator de moteur (6) à commutation électrique et un rotor de moteur (8) excité en permanence disposé sur un arbre/axe (9) du rotor, un circuit imprimé (16) libre de scellement étant prévu dans une zone sèche (14) du carter (4), le circuit imprimé comportant au moins un capteur (18) sans contact disposé sur un élément écarteur (30) pour détecter une position du rotor, ainsi que d'autres composants (20) électroniques liés électriquement au circuit imprimé (16) par des fils de raccordement (24, 26), **caractérisée en ce qu'**un élément de retenue (22) est prévu su lequel sont disposés le capteur (18) sans contact et les composants (20) électroniques et qui est disposé à distance du circuit imprimé (16) par les éléments écarteur (30), ledit élément de retenue (22) étant lié au circuit imprimé (16) par une jonction clipsée (32) de sorte que des zones de lavage (34) étendues sont formées qui garantissent un nettoyage du circuit imprimé (16) sans résidus après l'équipement.

2. Pompe de transport de liquide (2) à moteur électrique pour véhicule automobile selon la revendication 1, **caractérisée en ce que** les éléments écarteur (30) font partie intégrante d'éléments de centrage (28).

3. Pompe de transport de liquide (2) à moteur électrique pour véhicule automobile selon l'une quelconque des revendications 1 ou 2, **caractérisée en ce que** le rotor (8) du moteur est situé à l'extérieur et le stator (6) du moteur est situé à l'intérieur.

4. Pompe de transport de liquide (2) à moteur électrique pour véhicule automobile selon l'une quelconque des revendications précédentes, **caractérisée en ce que** la zone humide (12) avec le rotor (8) du moteur et un rotor de pompe est séparée de la zone sèche (14) comportant le stator (6) du moteur par un pot d'entrefer (10).

5. Pompe de transport de liquide (2) à moteur électrique pour véhicule automobile selon l'une quelconque des revendications précédentes, **caractérisée en ce qu'**une unité de commande (20) est prévue sur le circuit imprimé (16).

6. Pompe de transport de liquide (2) à moteur électrique pour véhicule automobile selon l'une quelconque des revendications précédentes, **caractérisée en ce que** le circuit imprimé n'est équipé que sur un côté, à savoir le côté tourné vers le moteur (6, 8).

7. Pompe de transport de liquide (2) à moteur électrique pour véhicule automobile selon l'une quelconque des revendications précédentes, **caractérisée en ce que** la pompe de transport (2) est une pompe de refroidissement.
